# EUROPEAN PATENT SPECIFICATION

(11) **EP 3 416 196 B1**
(45) Date of publication and mention of the grant of the patent: **17.09.2025**
(21) Application number: 18155274.6
(22) Date of filing: 06.02.2018
(51) Int. Cl.: H10F 19/90, H10F 77/20

(54) **SOLAR CELL MODULE, AND FABRICATING METHOD THEREOF**
SOLARZELLENMODUL UND HERSTELLUNGSVERFAHREN DAFÜR
MODULE DE CELLULE SOLAIRE ET PROCÉDÉ DE FABRICATION ASSOCIÉ

(30) Priority: 14.06.2017 KR 20170075019
(43) Date of publication of application: 19.12.2018
(73) Proprietor: Shangrao Xinyuan YueDong Technology Development Co. Ltd, Shangrao, Jiangxi Province (CN)
(72) Inventor: CHANG, Jaewon, 08592 Seoul (KR); KIM, Jinsung, 08592 Seoul (KR); YOON, Philwon, 08592 Seoul (KR)
(74) Representative: DREISS Patentanwälte PartG mbB

(56) References cited:
- WO-A2-2015/183827
- GB-A- 1 355 890
- US-A1- 2013 048 066
- US-A1- 2016 163 888

## Description

### BACKGROUND

### Field

The disclosure relates to a solar cell module, and a manufacturing method thereof, in which the shape of an electrode is improved, and a solar cell can be easily modularized and manufacturing cost can be reduced.

### Related Art

A solar cell may include a semiconductor, which can form pn junctions between different conductive types such as a p-type and an n-type, and electrodes that are respectively connected to the semiconductor having the different conductivity types. In some examples, a solar cell module may include multiple solar cells connected to each other, and the solar cell module can be used for power generation.

In some examples, to improve a power generation efficiency of a solar cell, a super cell is proposed in which cut cells are provided by dividing a standardized solar cell (for example, a solar cell made from a wafer) into multiple pieces, and these cut cells are partially overlapping each other and are electrically connected.

One reason for manufacturing a solar cell module with the cut cell may be to reduce the output loss. The power loss is proportional to the square of the current in the solar cell and the resistance of the solar cell. The current of the solar cell may include a current generated by the area of the solar cell itself. In this case, the current generated from the area of the solar cell itself increase as the area of the solar cell increases, and decreases as the area of the solar cell decrease. Therefore, the output loss can be reduced as the area of the solar cell is reduced.

Multiple cut cells are partially overlapped in an overlap region and are joined together with a conductive adhesive to form a series-connected module.

In order to connect the cut cells, a bus bar that connect the finger electrodes disposed on front and rear sides of the cut cell, or a pad that is provided separately from the electrodes, may be disposed in the overlap region of the cut cells. The bus bar or the pad of the neighboring two cut cells may be connected by a conductive adhesive or a solder.

In examples where a bus bar or a pad is provided separately from an electrode, manufacturing time and cost may increase.

In some examples, the pads or the bus bars needs to be aligned through an alignment process when the cut cells are connected to each other, which may also raise manufacturing time and cost. Examples of solar cell modules in the context of the invention are described in patent publications US 2013/048066 A1, WO 2015/183827 A2 and US 2016/163888 A1.

### SUMMARY

The disclosure has been made in view of the above technical background, and may easily and simply modularize a solar cell and reduce manufacturing cost of the solar cell.

The disclosure may solve various technical problems, and the problems not described herein can be easily understood from the description of the disclosure or from the description of the disclosure by those skilled in the art.

The invention is defined by the solar cell module described in claim 1 and the method of manufacturing a solar cell module defined in claim 11. According to one aspect of the subject matter described in this application, a solar cell includes a semiconductor substrate including a short side that extends in a first direction and a first long side that extends in a second direction that is different than the first direction, and a plurality of electrodes disposed on at least one surface of the semiconductor substrate, in which each electrode includes a junction that comprises a conductive material and that provides an electrical and physical connection to the semiconductor substrate. The plurality of electrodes are arranged physically apart from each other in the second direction.

Implementations according to this aspect include one or more of the following features. For example, the junction may be located at an end of each electrode adjacent to the first long side of the semiconductor substrate. An area occupied by the plurality of electrodes may be less than or equal to 5% of a total area of the at least one surface of the semiconductor substrate. The plurality of electrodes may be spaced apart from the first long side by a distance of 200 µm to 300 µm in the first direction. The plurality of electrodes may include 80 to 120 electrodes, and the plurality of electrodes may be spaced apart from each other by a distance of 1 mm to 2 mm in the second direction. The distance between neighboring electrodes in the plurality of electrodes in the second direction may be constant.

In some implementations, a distance between two neighboring electrodes of the plurality of electrodes in the second direction decreases along the first direction, and neighboring junctions of the two neighboring electrodes may be positioned at locations in which the distance between the two neighboring electrodes in the second direction is at a minimum. A maximum line width of the plurality of electrodes may be 3 to 5 times greater than a minimum line width of the plurality of electrodes in the second direction. Each electrode of the plurality of electrodes may have a needle shape and has a line width in the second direction decreasing along the first direction.

In some implementations, the solar cell further includes a busing portion that physically connects, in the second direction, two neighboring electrodes among the plurality of electrodes, the busing portion may be located closer to a second long side opposite the first long side, and the junction may be located closer to the first long side than to the second long side.

In the invention, the junction has an aspect ratio of 1/26 to 3/10 corresponding to a ratio between a length in the second direction and a length in the first direction. The plurality of electrodes may further include a finger portion extending from the junction in the first direction and having a line width less than a line width of the junction in the second direction. In the invention, the junction defines an open pattern through which a portion of the semiconductor substrate is exposed. A unit area of the junction is larger than a unit area of a portion of the plurality of electrodes that excludes the junction.

According to another aspect of the subject matter, a solar cell module includes a plurality of solar cells. Each solar cell includes a short side that extends in a first direction, a long side that extends in a second direction that is different than the first direction, a first electrode located on a first surface of each solar cell, a second electrode located on a second surface of each solar cell, and an overlap region disposed at the long side and configured to partially overlap a neighboring solar cell along the long side. The plurality of solar cells include a first solar cell and a second solar cell neighboring the first solar cell, and the solar cell module further includes a conductive adhesive that electrically and physically connects the second electrode of the first solar cell to the first electrode of the second solar cell at the overlap region. The first electrode includes a plurality of electrodes that are physically spaced apart from each other in the second direction in which each of the plurality of electrodes includes a junction disposed in the overlap region.

Implementations according to this aspect may include one or more of the following features. For example, the conductive adhesive may be provided on an entirety of the overlap region. A unit area of the junction may be larger than a unit area of a portion of the plurality of electrodes that excludes the junction. The junction of each of the plurality of electrodes of the first electrode located on the second solar cell may be configured to be covered by the first solar cell.

According to another aspect of the subject matter, a method for manufacturing a solar cell module, which includes first and second solar cells, each solar cell comprising a short side that extends in a first direction, a long side that extends in a second direction that is different than the first direction, includes applying a conductive adhesive to the second solar cell, the second solar cell including a plurality of electrodes that include a junction at an end of each electrode and that are arranged in parallel to the second direction, positioning the first solar cell over the second solar cell at an overlap region in which the conductive adhesive is applied, and curing the conductive adhesive to physically and electrically connect the first solar cell to the second solar cell. The junction is disposed in the overlap region based on the first solar cell overlapping the second solar cell, and the conductive adhesive is configured to connect the junction in the overlap region to a neighboring electrode that is spaced apart from the junction in the second direction.

Implementations according to this aspect may include one or more of the following features. For example, the conductive adhesive may be applied on an entirety of the overlap region.

When a part of the solar cell is overlapped and modularized, electrodes, which are physically separated, can be electrically connected to each other by a conductive adhesive. In addition, two neighboring solar cells may be mechanically and electrically connected by a conductive adhesive, which may reduce manufacturing cost and time.

### BRIEF DESCRIPTION OF THE DRAWINGS

FIG. 1 illustrates a schematic plan view of an example solar cell module manufactured using example cut cells.
FIG. 2 illustrates a sectional view taken along the line A-A' in FIG. 1.
FIGS. 3 and 4 are schematic views for an example process of producing cut cells from a mother cell.
FIGS. 5 to 17 are views illustrating example solar cells having electrodes of various shapes.
FIG. 18 is a flowchart illustrating an example method of manufacturing a solar cell module.
FIG. 19 is a view illustrating an example mask pattern to manufacture an electrode in a needle shape.
FIG. 20 is a diagram schematically illustrating steps S11 and S13 of FIG. 18.
FIG. 21 is a cross-sectional view taken along line B-B 'of FIG. 20.

### DETAILED DESCRIPTION

Reference will now be made in detail to implementations of the disclosure, examples of which are illustrated in the accompanying drawings.

This disclosure may, however, be implemented in many different forms and should not be construed as limited to the implementations set forth herein. Wherever possible, the same reference numbers will be used throughout the drawings to refer to the same or like parts. It will be noted that a detailed description of known arts will be omitted if it is determined that the detailed description of the known arts can obscure the implementations of the disclosure. In addition, the various implementations shown in the drawings are illustrative and may not be drawn to scale to facilitate illustration. The shape or structure can also be illustrated by simplicity.

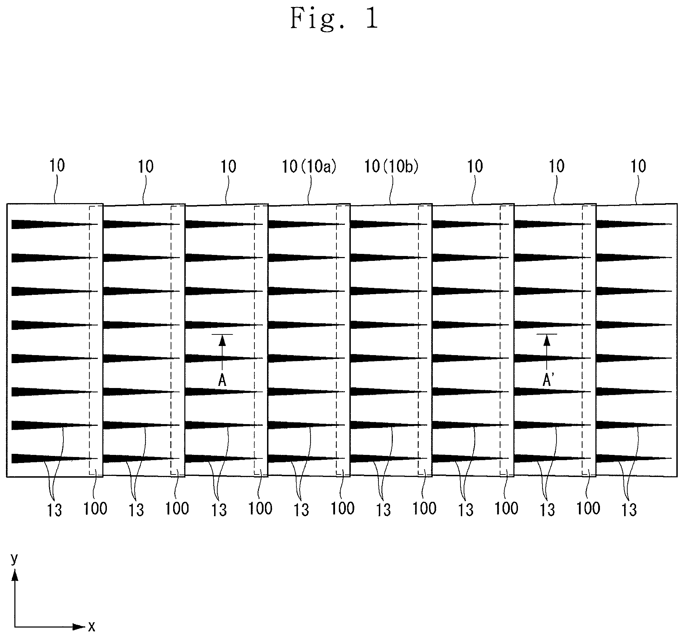

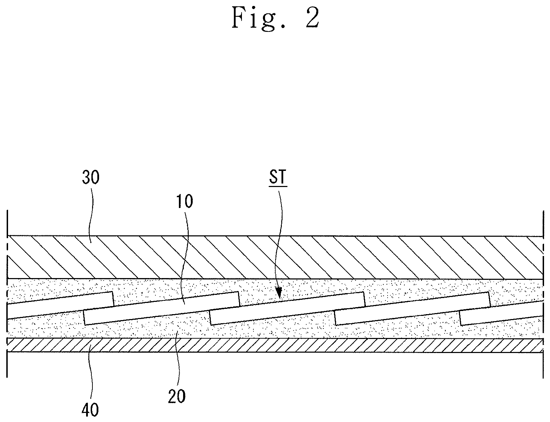

FIG. 1 illustrates a schematic plan view of an example solar cell module manufactured using cut cells, and FIG. 2 illustrates a sectional view taken along the line A-A 'in FIG. 1.

Referring to FIGS. 1 and 2, a plurality of solar cells are positioned so as to partially overlap with neighboring solar cells, and a conductive adhesive is provided in the overlap region 100. Two solar cells are electrically and mechanically connected to form a string ST.

In one implementation, the solar cell 10 may be configured to include a plurality of electrodes 13 arranged on the front surface and extended in one direction (e.g., the x-axis direction in FIG. 1). The plurality of electrodes 13 provided on the front surface are spaced apart from the neighboring electrodes 13 in the second direction (e.g., the y-axis direction in FIG. 1), and the electrodes 13 may be arranged to dispose on the same line as the electrodes of the other solar cells neighboring in the first direction, for example, along the x-axis direction in FIG. 1.

The neighboring first and second solar cells 10a and 10b are electrically and mechanically connected by the conductive adhesive provided in the overlap region 100, and the electrodes 13 disposed on the solar cell are electrically connected. The conductive adhesive comprises an organic/polymer matrix and a metal filler in which the metal filler provides an electrical property, and the polymer matrix is configured to provide physical and mechanical characteristics of the conductive adhesive.

A portion of the first solar cell 10a is disposed on the front surface of the second solar cell 10b in the overlap region 100. For example, a portion of the rear surface of the first solar cell 10a and a portion of the front surface of the second solar cell 10b overlap in the overlap region 100. The electrodes disposed on the rear surface of the first solar cell 10a and the electrodes disposed on the front surface of the second solar cell 10b face each other in the overlap region 100, and are electrically connected by the conductive adhesive provided on the overlap region 100. As a result, the first solar cell 10a and the second solar cell 10b are electrically and mechanically connected to the overlap region 100 by a conductive adhesive.

In some implementations, a width of the overlap region 100 in the x-axis direction may be 1/20 to 1/15 of a width of the solar cell 10 in the x-axis direction in consideration of adhesive force of the conductive adhesive. If the width of the overlap region 100 is smaller than 1/20, the overlap region 100 is too small to provide a sufficient mechanical bonding strength. If the width of the overlap region 100 is larger than 1/15, the overlap region 100 becomes too large, and the power generation efficiency of the solar cell is lower than expected. In consideration of these points, in one example of the disclosure, the width of the overlap region 100 may be 1 mm to 2.5 mm.

As illustrated in FIG. 2, the string ST is laminated between the front transparent substrate 30 and the back sheet 40 to form a solar cell module.

For example, the front transparent substrate 30 is positioned on the front surface of the string ST, and the back sheet 40 is disposed on the rear surface of the string ST. In a state in which a transparent filler material 20 such as a polymer sheet (e.g., Ethylene Vinyl Acetate) is disposed between the front surface of the string ST and the front transparent substrate 30 and between the rear surface and back sheet of the string ST, heat and pressure are applied to them simultaneously to integrate them into a solar cell module.

In some examples, the front transparent substrate 30 may be made of tempered glass having a high transmittance and excellent breakage-preventing function.

The back sheet 40 can prevent penetration of moisture from the back surface of the string ST, thereby protecting the solar cell from the external environment. Such a back sheet 40 may include a multi-layer structure that may include, for example, a layer preventing moisture and oxygen penetration and a layer preventing chemical corrosion.

The back sheet 40 may be made of a thin sheet of an insulating material such as fluoropolymer (FP), polyester (PE), or any combination thereof, but may be an insulating sheet made of another insulating material.

In some implementations, the lamination process may be provided with the encapsulant 20 having a sheet shape disposed between the front transparent substrate 30 and the string ST and between the string ST and the back sheet 40.

For example, the material of the encapsulant 20 may include a material such as ethylene vinyl acetate (EVA) which can prevent corrosion due to moisture penetration and protect the string ST from impact.

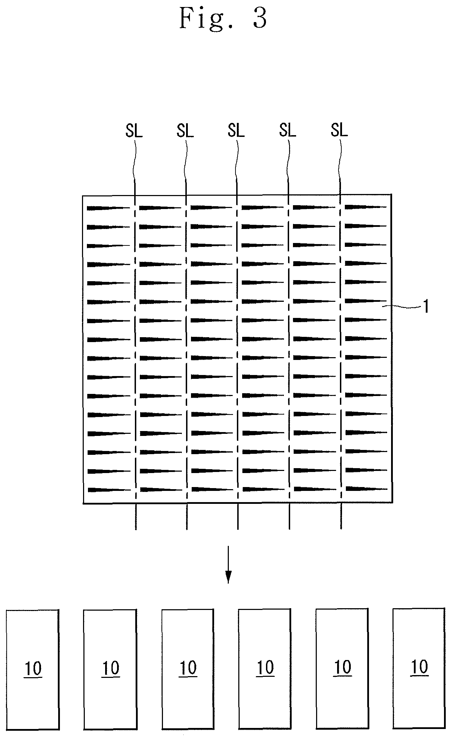

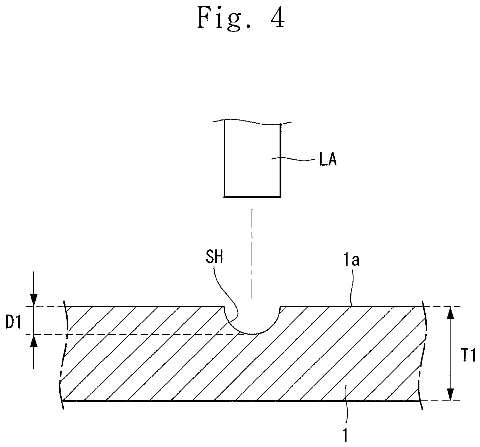

The solar cell of the solar cell module described above can be made into a cut cell. As shown in FIGS. 3 and 4, the cut cell 10 can be made by dividing one standardized solar cell (hereinafter referred to as a mother cell) made from a wafer into a plurality of solar cells. In the drawings, it is exemplified that one mother cell 1 is divided into six to produce six cut cells 10.

The mother cell 1 may be configured to include a plurality of divided electrodes 13 so as to be easily divided into a plurality of cut cells. The electrodes 13 are divided into a plurality of portions based on the scribing lines SL so as to be easily separated along the scribing lines SL. In one example, the mother cell 1 can be divided into six cut cells 10, and the electrodes 13 can also be divided into six in the longitudinal direction.

In some examples, the electrodes 13 are located on the same lines extending in the longitudinal direction (e.g., the x-axis direction in FIG. 1). In this regard, when the mother cell 1 is divided into the plurality of cut cells 10, the electrodes arranged for each cut cell 10 can be arranged in the same shape and the same position. Therefore, when the cut cells 10 are arranged to overlap with each other to form a solar cell module, the positions of the electrodes 13 can be easily adjusted.

The electrodes arranged in the mother cell 1 may extend in the longitudinal direction as shown in FIG. 3. Since the electrode has a simple shape, the manufacturing process for forming the electrode can be simplified, and the manufacturing cost can be reduced. In addition, when the mother cell 1 is divided into a plurality of cut cells 10, and the cut cells 10 then overlap each other, it may be easy to arrange the positions of the electrodes disposed in the cut cells to be located on the same line in the longitudinal direction.

Also, from the point of view of design, since the electrode arrangement of the mother cell 1 is substantially the same as the electrode arrangement of the solar cell module made with the cut cells 10, the difference in design between the solar cell module made with the cut cells 10 and the mother cell 1 can be reduced.

For example, the mother cell 1 is divided into 3 to 12 cut cells. If the mother cell 1 is divided into less than 3 cut cells, it may be difficult to effectively reduce the output loss. If the mother cell 1 is divided into 12 or more cells, the output may be reduced due to the damage occurring in the process of dividing the mother cell 1.

In examples where the cut cells 10 are provided by dividing the mother cell 1, the cut cell may have a rectangular shape having a short side and a long side, while the mother cell 1 may have a different shape. The aspect ratio (the length of the short side / the length of the long side) of the cut cell is determined according to the number of divided portions, for example, 1/3 to 1/12. When the aspect ratio has a value in the range of 1/3 to 1/12, sufficient overlapping areas can be ensured when the cut cells are modularized, thereby achieving the required sufficient mechanical bonding strength.

The mother cell 1 includes a semiconductor substrate which can form a pn junction, a back surface field, a passivation layer, electrodes for collecting electric charge, etc., which is a constitution necessary for electric power generation. In the drawings, these configurations are omitted for convenience of explanation. The mother cell 1 can be used for various kinds of solar cells such as a HIT (heterojunction with intrinsic solar cell), a bifacial solar cell, and a back contact solar cell. The mother cell 1 can be divided into a plurality of cut cells with laser irradiated along the scribing line SL.

For example, the laser LA is irradiated on the opposite surface of the light receiving surface of the mother cell 1 which receives light. When the laser beam is irradiated to the mother cell 1, the surface of the solar cell is melted by the laser, and a groove is provided while cooling. However, due to heat of the laser during the irradiation of the laser, the periphery of the groove is also heated to a high temperature in this process, and the combination between the stabilized silicon (Si) may be broken and the recombination site may increase.

In some examples, the laser LA is irradiated out of the region where the pn junction is provided. The mother cell 1 produces electricity by the pn junction between the semiconductor substrate and the emitter layer. Therefore, if the laser is irradiated to the region where the emitter is provided, the pn junction may be damaged by the laser, so that the power generation efficiency of the solar cell is inevitably lowered.

In some examples where a solar cell has a general structure in which an emitter is provided on the front surface of the mother cell 1, and an electrode is provided on the front surface and the rear surface of the solar cell, the laser can be irradiated on the back side of the solar cell where the emitter is not provided.

In the back contact solar cell in which both the emitter and the back surface field are provided on the rear surface of the semiconductor substrate, the laser is irradiated to the rear surface which is the opposite surface of the light receiving surface, but can be irradiated outside the region where the emitter is provided.

As describing above, the laser may be irradiated to an outside of the pn junction, where the carrier is produced, to prevent the power generation efficiency of the solar cell from being reduced.

As the laser is irradiated along the scribing line SL, the groove SH is formed on the surface 1a of the mother cell 1 along the scribing line SL. For example, the scribing line SL may be a virtual line indicating the direction in which the laser is irradiated to the solar cell to divide the mother cell 1. In some examples, the laser may be a pulsed laser to reduce damage by the laser. Since the pulsed laser is irradiated in synchronization with pulses, the laser is intermittently irradiated without being continuously irradiated during the scan of the mother cell 1, so that the thermal energy applied to the solar cell can be reduced. In some examples, the laser LA is irradiated multiple times, rather than irradiating once along the respective scribing lines SL to form the grooves SH. The number of times of irradiation can be adjusted in consideration of the intensity of the laser, the depth D1 of the groove SH, and the like. The laser can be irradiated with a reduced intensity to effectively reduce damage to the solar cell during the scribing process.

In some examples, the depth D1 of the dividing groove SH is, for example, 50% to 70% of the thickness T1 of the mother cell 1. After the groove SH is provided, the mother cell 1 receives physical force and is divided into a plurality of cut cells 10. After the groove SH is provided, a physical force is applied to the mother cell 1, so that the mother cell 1 can be divided into a plurality of cut cells 10. However, if the depth D1 of the groove SH is smaller than 50%, the mother cell 1 cannot be divided along the groove SH, and a defect such as a crack can be generated in the mother cell 1. When the depth D1 of the dividing groove SH is 70% or more, the thermal stress induced to the mother cell 1 increases, and the efficiency of the cut cell 10 can be reduced.

Hereinafter, example solar cells having various shapes of electrodes will be described in detail with reference to the accompanying drawings.

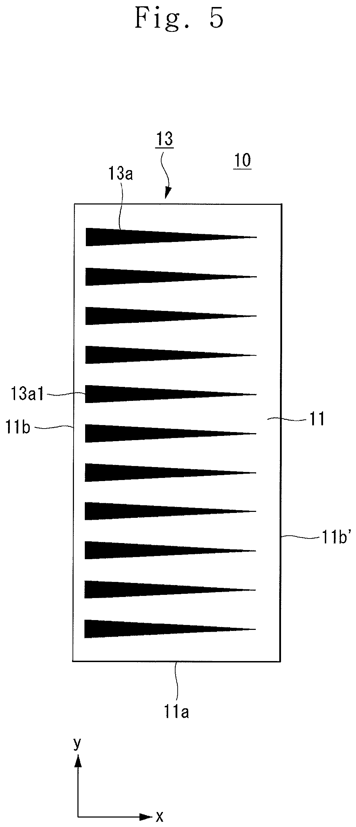

FIG. 5 shows a plan view of an example solar cell. The solar cell 10 may include a semiconductor substrate forming a pn junction and a first electrode and a second electrode respectively provided on the first and second surfaces of the semiconductor substrate. For example, the first electrode may be positioned on the first surface, and the second electrode may be disposed on the opposite surface of the front surface.

Various implementations will be described by exemplifying the first electrode and the first electrode among the second electrodes. However, the disclosure is not limited thereto, and the first electrode or the second electrode either or both may have the same shape as the first electrode described below.

The semiconductor substrate 11 may have a short side 11a extending in a first direction (e.g., the x-axis direction in FIG. 5) and a long side 11b extending in a second direction (e.g., the y-axis direction in FIG. 5). In some examples, the aspect ratio of the semiconductor substrate 11 may be 1/3 to 1/12.

The first electrode 13 is located on the front surface of the semiconductor substrate 11 and may be provided to have a sprite arrangement physically separated from the neighboring one in the second direction. For example, the first electrode 13 is provided to occupy not more than 5% of the front surface area of the semiconductor substrate 11 so as not to block the light incident on the front surface as much as possible. If the area of the first electrode 13 is 5% or more, the light receiving area of the first electrode 13 may be reduced, resulting in an undesired output. In addition, the manufacturing cost may increase.

In some examples, the area where the first electrode 13 is provided is 3% or less of the area of the front surface of the semiconductor substrate 11.

In some implementations, the first electrode 13 is provided so as to have a structure without a bus electrode. In the related art, the first or second electrode generally comprises a plurality of finger electrodes for collecting electric charge, and a bus electrode connecting the finger electrodes to each other, where the bus electrode is connected to a ribbon connecting solar cells. However, since the bus electrode is connected to the ribbon, the bus electrode has a line width larger than that of the finger electrode, resulting in an increase in manufacturing cost and a reduction in the light receiving area.

In the present disclosure, considering this point, the first electrode 13 disposed on the front surface may be provided so as to have a junction 13a including a portion of the first electrode 13 rather than forming a bus electrode.

When the solar cell 10 is overlapped with the neighboring long side 11b, the junction 13a is provided with a conductive adhesive material for electrical and mechanical connection. As a result, the first electrodes 13 spaced apart in the second direction are electrically and physically connected to each other by the conductive adhesive.

In some examples, the junction 13a may include a part of the first electrodes 13, and may be provided individually for the first electrodes 13. For example, as shown in FIG. 5, the junction 13a may include a portion including the end portion 13a1 of the first electrode 13 adjacent to the long side 11b. The unit area of the junction 13a may be larger than the unit area of the first electrode 13 excluding the junction 13a. The unit area is an area where the electrode is provided in a predetermined area. For example, the unit area may be an area where an electrode is provided per 1 mm².

Regarding FIG. 5, the first electrode 13 including the junction 13a may be provided to have a needle shape in which the line width in the second direction gradually decreases in the first direction. The junction 13a including a part of the end portion 13a1 of the first electrode 13 has a relatively larger unit area than the other area excluding the junction 13a. Accordingly, when the solar cells overlap with each other around the junction 13a, the electrodes of the two overlapping solar cells can be bonded with a sufficient area. Therefore, electrodes of two solar cells overlapping each other can be bonded without using a pad or a bus electrode discussed in the related art.

In this implementation, since the first electrode 13 has a needle shape in which the line width gradually decreases, the area where the first electrode 13 is provided can be configured to be 5% or less of the front surface of the semiconductor substrate, i.e., the light receiving surface.

In some examples, when the mother cell of M4 size (161.7 mm × 161.7 mm) used in the industrial field is divided into 6, for example, the number of the first electrodes 13 can be 80 or more to 120. The interval (or pitch) D2 between the first electrodes 13 may be, for example, about 1 mm to about 2.0 mm. If the distance between the first electrodes 13 is less than 1 mm, the interval between the electrodes is too dense, the power generation efficiency is lowered due to the shadow effect, and the manufacturing cost may increase, which lowers the price competitiveness. If the interval between the first electrodes 13 is larger than 2.0 mm, the interval between the electrodes is too wide to collect the charge generated by light. The end portion 13a1 of the first electrode 13 is, for example, spaced apart from the long side 11b by 200 µm to 300 µm. As described above, a mother cell 1 is divided into a plurality of cut cells 10 with a laser scribing process. In this case, the first electrode 13 may be provided at a distance of 200 µm to 300 µm from the long side 11b in consideration of the laser resolution and the operation margin.

In some examples, the end portion 13a1 of the first electrode 13, that is, the maximum line width is, for example, 120 µm to 200 µm. Since the end portion 13a1 forms the junction 13a as described above, the end portion 13a1 must be at least 120 µm in order to ensure a minimum junction area, if it is larger than 200 µm, the area of the first electrode 13 is excessively turned on, which increases manufacturing cost.

In some examples, a minimum line width of the first electrode 13 is 40 µm in the y-direction of FIG. 5. If the minimum line width of the first electrode 13 is less than 40 µm, an edge curl phenomenon in which the ends of the electrodes are curled up, may occur during screen printing and firing of the electrodes.

In view of this problem, a maximum line width of the first electrode 13 may be 3 to 5 times the minimum line width of the first electrode.

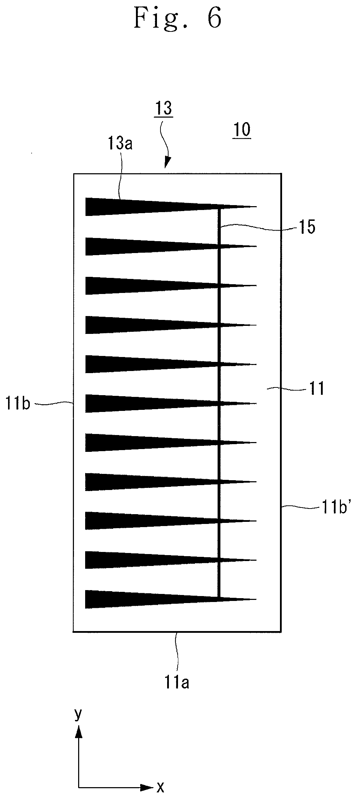

In some examples where the first electrode 13 has a needle-like shape, the spaces between the first electrodes 13 gradually increase in the second direction (y-axis direction in the figure). In this case, it may be difficult to normally collect the charge generated at the electrode end portion (opposite side of the junction) of the first electrode 13. In consideration of such a problem, as shown in FIG. 6, the electrodes 13 may further include a busing portion 15 which connects the first electrodes 13. The busing portion 15 may be arranged to be closer to the right long side 11b' facing the left long side 11b than to the left long side 11b.

In some examples, the line width of the busing portion 15 may be, for example, about 50 µm considering the manufacturing process, manufacturing cost, the area where the first electrode 13 is provided on the front surface, and the like.

The busing portion 15 may be provided to be smaller than the average line width of the first electrode 13 as compared with the first electrode 13. If the line width of the busing portion 15 is larger than the average line width of the first electrode, it is difficult to form the first electrode 13 so as to have an area of 5% or less. Here, the average line width is an average value of the maximum line width and the minimum line width of the first electrode.

As illustrated in Fig. 6, the busing portion 15 extends in parallel with the right long side 11b' in the y-axis direction, intersects with the extending direction of the first electrode 13, and is connected to the entire first electrode 13.

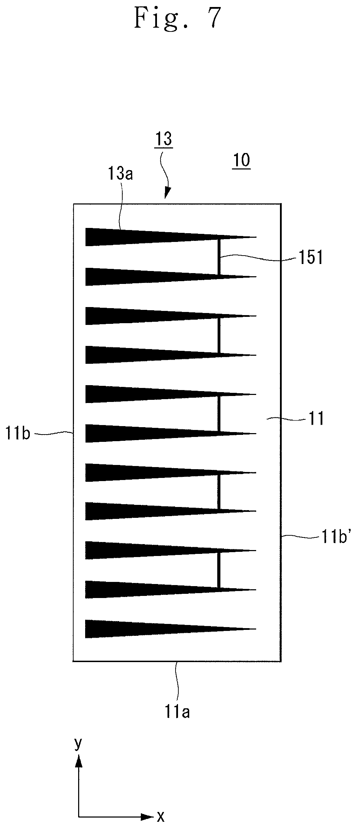

In the implementation shown in FIG. 6, the plurality of first electrodes 13 are all connected by the busing portion 15, but it is not necessarily provided like this example. In consideration of the manufacturing cost and the light receiving area, the busing portion 15 may be partially provided as illustrated in FIG. 7. As illustrated in FIG. 7, the busing portion 151 is arranged so as to connect only two first electrodes 13 neighboring in the second direction (y-axis direction in the drawing), but considering the correlation between the light receiving area and the manufacturing cost, the busing portion 151 may be provided to have various shapes.

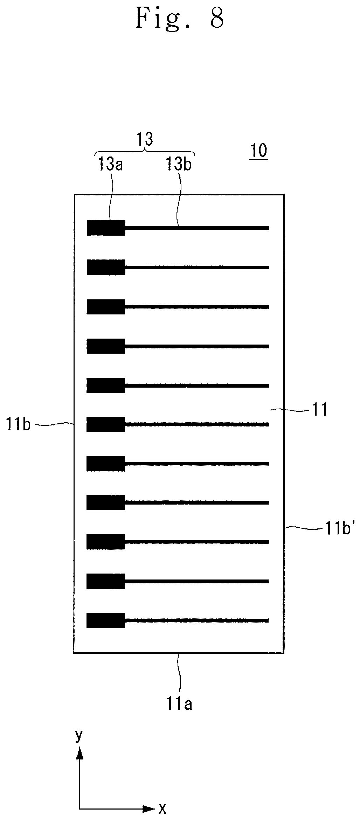

Referring to Fig 8, in this implementation, the first electrode 13 is physically spaced apart from the neighboring electrode in the second direction (e.g., the y-axis direction in the drawing), and may be provided to have a striped arrangement.

Also, each of the first electrodes 13 includes a junction 13a adjacent to the long side 11b and a finger portion 13b extending from the junction 13a in the first direction (e.g., the x axis direction in the drawing).

The junction 13a can have a rectangular shape, where the length in the x-axis direction may be 0.5 mm to 1.3 mm, and the width in the y-axis direction may be 50(um) ~ 150(um) larger value than a width of the finger portion 13b. In the invention, the junction 13a may have an aspect ratio (width / length) of 1/26 to 3/10. If the aspect ratio of the junction 13a is smaller than 1/26, the junction 13a becomes too thin and it is difficult to secure a sufficient bonding area when the first and second solar cells are overlapped. If the aspect ratio of the junction 13a is larger than 3/10, the junction 13a is unnecessarily thickened and only the manufacturing cost is increased.

The reason that the junction 13a is longer the horizontal direction than the vertical direction is that the first electrode of the first solar cell can effectively contact the second electrode of the second solar cell when the first and second solar cells are overlapped.

In one implementation, the first solar cell and the second solar cell are overlapped by about 1.5 mm.

In some implementations, the second electrode provided on the rear surface of the first solar cell has the same shape as the first electrode but may be arranged with mirror-symmetry of the first electrode. When the first electrode of the second solar cell and the second electrode of the first solar cell overlap, the junction of the first electrode and the junction of the second electrode in the overlap region can be arranged to face each other.

For example, since the junction 13a extends in the longitudinal direction (x-axis direction in the drawing), the junction of the first electrode and the junction of the second electrode facing each other in the overlap region can be connected with a sufficient contact area in the longitudinal direction (x-axis direction in the drawing).

As described above, when the first electrode and the second electrode are connected to each other, the area where the conductive adhesive is provided is increased, thereby effectively reducing the line resistance occurring at the area where the first electrode and the second electrode are connected.

In the invention, the first electrode 13 includes an open pattern 131 for allowing the heat to be easily discharged in the process of firing the paste when the first electrode 13 is provided by a screen printing process.

The open pattern 131 may also increase the surface area of the junction 13a to increase the area to which the conductive adhesive is applied when connecting two neighboring solar cells so that the conductive adhesive can be sufficiently applied to the junction 13a. Further, the open pattern 131 may prevent the conductive adhesive having viscosity from flowing to the periphery when it is supplied to the junction 13a.

In some examples, the open pattern 131 may be provided as an open space in which a part of the junction 13a is removed.

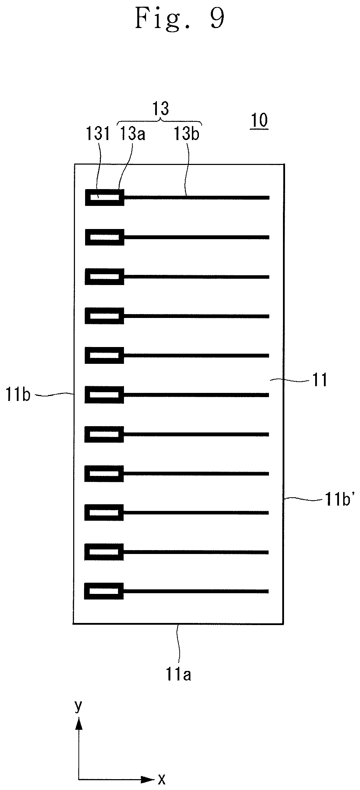

Such an open pattern 131 may be provided to have various shapes without particular limitation, and various examples thereof are illustrated in Figs. 9 to 14.

Referring to Fig. 9, the open pattern 131 may be provided in the junction 13a and have a substantially rectangular shape. In this case, the junction 13a has a 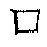 -shaped shape.

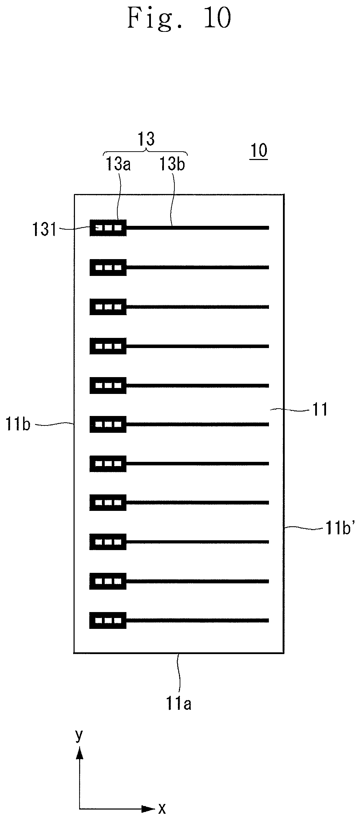

In comparison with this example, the open pattern 131 shown in Fig. 10 differs from the open pattern 131 shown in FIG. 9. The open pattern 131 in Fig. 10 includes at least two divided spaces.

When the open pattern 131 is provided as described above, the conductive adhesive can be confined in the open pattern 131 in the process of applying the conductive adhesive, so that the bonding strength between the first solar cell and the second solar cell can be strongly obtained.

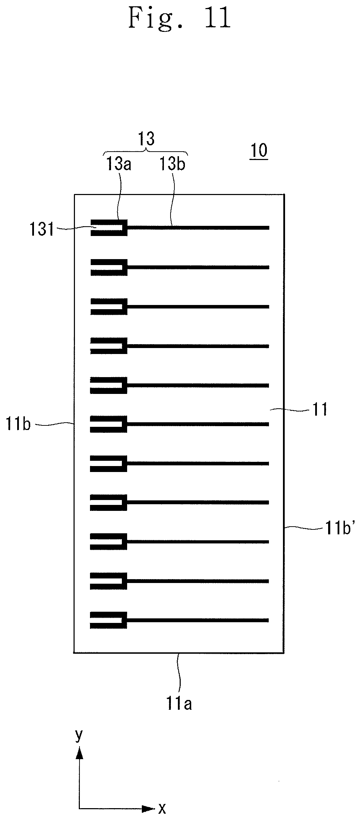

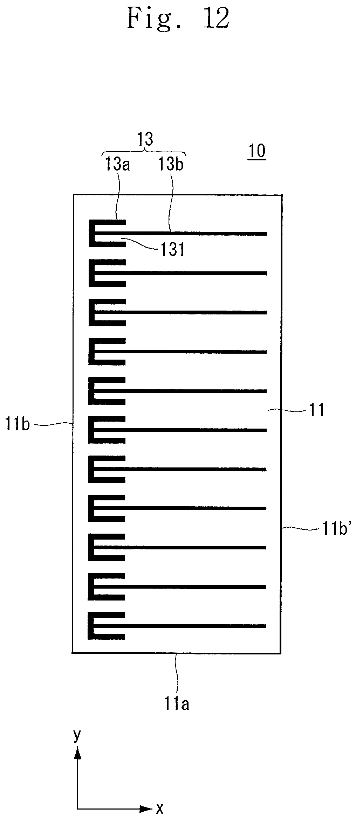

Referring to Figs. 11 and 12, the open pattern 131 of each implementation differs from the open pattern of the previous implementations in that it is provided as an open space. As shown in FIG. 11, the open pattern 131 of this implementation can be provided to have a horseshoe shape.

The open pattern 131 illustrated in FIG. 11 has a left open shape, and the open pattern 131 illustrated in FIG. 12 has a right open shape.

In these implementations, heat and gas, which can be generated in the process of firing the conductive adhesive provided to the junction 13a, can be easily discharged.

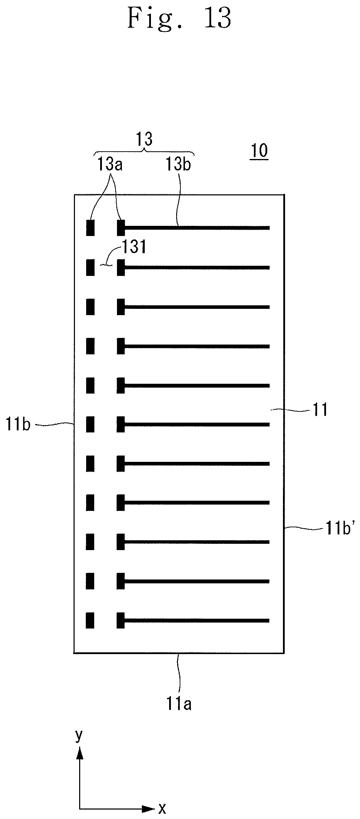

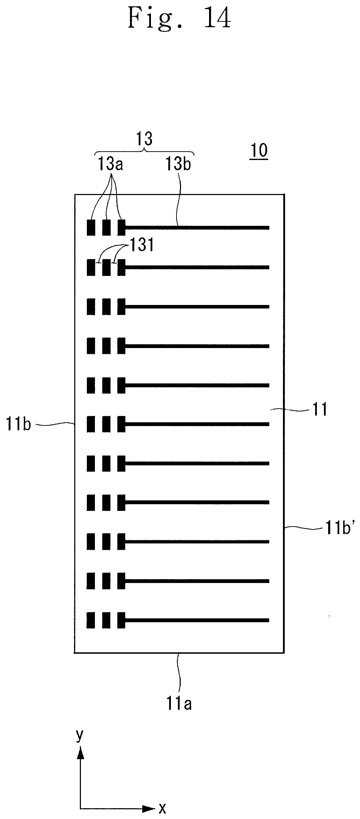

Referring to Figs. 13 and 14, the open pattern 131 of these implementations may be provided to have an open shape at the top and bottom, and a closed shape at the left and right. The junction 13a may be provided to have a shape facing away from the first direction (the x-axis direction in the drawing) and they face with each other.

The open patterns 131 of these implementations may be advantageous in that it is easy to apply the conductive adhesive at the overlap region. For example, the conductive adhesive may be provided long in the second direction (y-axis direction in the drawing). The open pattern 131 of this implementation may be opened up and down while closed to the left and right. Therefore, the conductive adhesive supplied to the junction 13a is guided by the junction 13a and the open pattern 131, and therefore the conductive adhesive can be applied in a long direction in the second direction.

Although the open pattern described above are illustrated as a rectangular shaped junction 13a, the disclosure is not limited thereto. The open portion described above can be provided in the same manner in the junction 13a of all the implementations described throughout this specification.

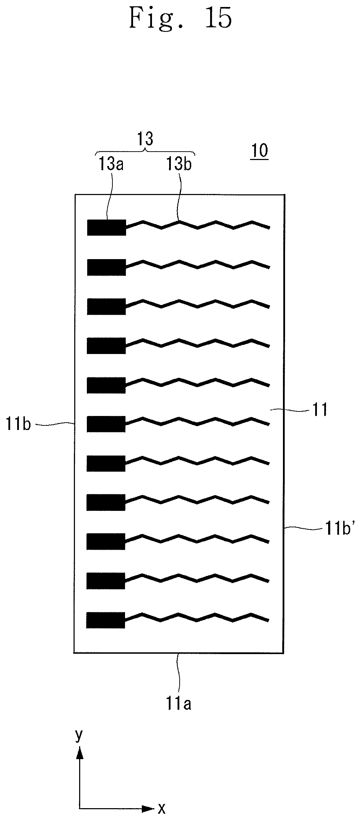

FIG. 15 illustrates a plan view of an example first electrode.

Referring to FIG. 15, each of the first electrodes 13 of the first electrode 13 includes a junction 13a adjacent to the long side 11b and a finger 13b extending from the junction 13a in the first direction (x-axis direction of the drawing).

In this example, the finger 13b may have a zigzag shape or a wavy pattern. In other examples, the finger 13b is provided to have a straight shape along the short side of the semiconductor substrate 11 to be short, but in this implementation, since the finger 13b has a zigzag shape, the finger 13b can be provided longer.

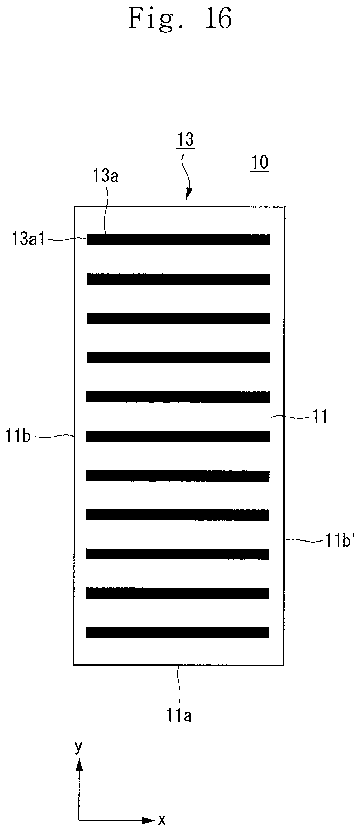

Fig. 16 shows a plan view of an example solar cell.

Referring to FIG. 16, the first electrodes 13 are arranged in parallel to the neighboring electrodes in the second direction, and the distance between the neighboring first electrodes 13 in the second direction is constant.

In this implementation, the distance between the first electrodes is 1 to 2 mm, the number of the first electrodes 13 is 80 to 120, and the line width is 50 µm to 120 µm. When the line width is less than 50 µm, the line width of the electrode is too thin to collect the charge, and when the line width is larger than 120 µm, the light receiving area can be reduced due to the shadow effect.

In this implementation, the junction 13a is provided as a part of the first electrode 13 and, for example, a portion including the end portion 13a1 of the first electrode 13 may form the junction 13a. The junction 13a is located adjacent to the long side 11b.

Since the conductive adhesive is provided along the long side 11b when overlapping two neighboring solar cells, the first electrodes 13 physically separated from the second direction can be electrically and physically connected by the conductive adhesive.

Therefore, even if the junction 13a is provided as a part of the first electrode 13, has a thin line width, and is apart from the neighboring portion in the second direction (y-axis direction in the drawing), neighboring solar cells can easily be physically and electrically connected by a conductive adhesive without alignment problems between electrodes.

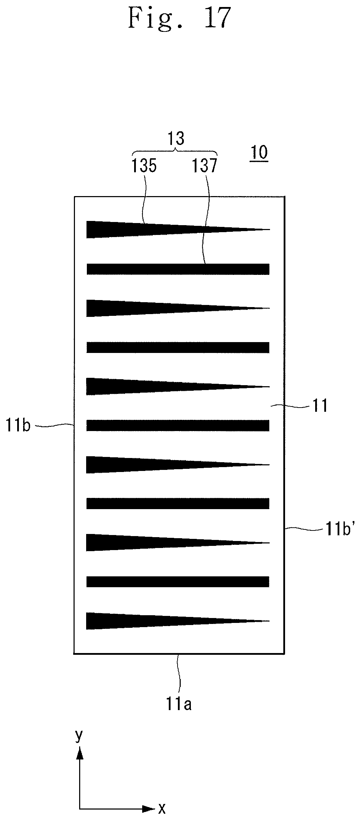

Fig. 17 shows a plan view of an example solar cell.

In this implementation, the first electrode 13 may include a first electrode portion 135 and a second electrode portion 137 having different sizes of junction.

The first electrode portion 135 and the second electrode portion 137 are arranged in parallel with each other in the second direction and each includes junctions 1351 and 1371 at one end. Here, each of the junctions 1351 and 1371 may be provided so as to be adjacent to the left long side 11b.

As shown in Fig. 17, the first electrode portion 135 may have a needle shape, while the second electrode unit 137 may have a straight line shape. The junction 1351 of the first electrode 135 has a larger area than the junction 1371 of the second electrode 137.

According to this implementation, it may be possible to reduce the problems that may occur in implementations where the first electrode portion 135 is provided only or the second electrode portion 137 is provided only. There may be advantages of having both the first and second electrode portions. For example, in the implementation including only the first electrode portion 135, the area occupied by the first electrode is larger than that in the implementation including only the second electrode portion 137. As a result, the manufacturing cost of the solar cell is increased and the light receiving surface is reduced, but a sufficient junction area can be secured. As a result, the solar cell provided only with the first electrode portion 135 has a problem in that the manufacturing cost is increased and the light receiving surface is reduced, but a sufficient junction area can be secured.

In contrast, in the implementation including only the second electrode portion 137, the area occupied by the first electrode is smaller than that of the implementation including only the first electrode portion 135, so that the manufacturing cost is reduced and the light receiving surface is widened. However, there is a problem that the junction area is reduced.

In this implementation, in consideration of the above advantages and disadvantages, the first electrode portion 135 and the second electrode portion 137 having different junction area are appropriately disposed.

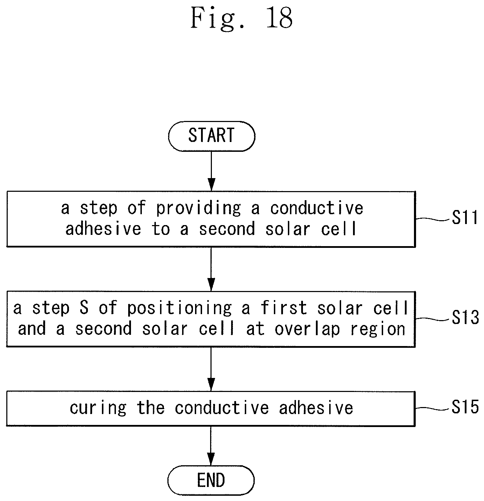

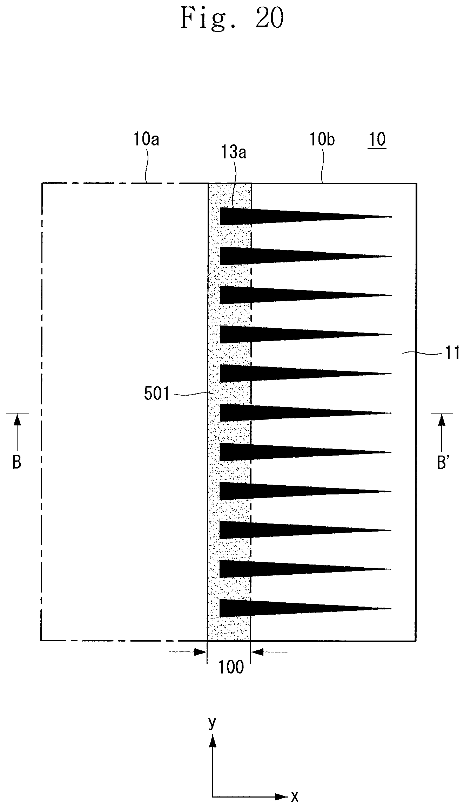

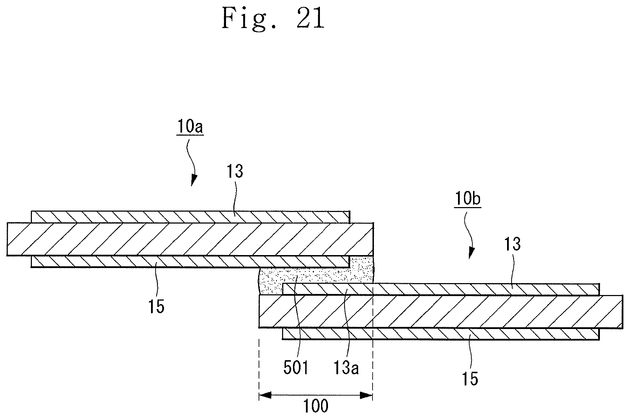

Hereinafter, a solar cell module and a method of manufacturing the same will be described with reference to Figs. 18 to 21.

Referring to these drawings and the above-mentioned drawings, a solar cell module includes a plurality of solar cells 10 having the long side partially overlapped in the overlap region 100. Each of the plurality of solar cells 10 has a long side in a first direction (x-axis direction in the drawing) and a short side in a second direction (y-axis direction in the drawing).

The second electrode 15 positioned on the second surface of the adjacent first solar cell 10a among the plurality of solar cells and the first electrode located on the first surface of the second solar cell 10b 13 are electrically and physically connected directly by the conductive adhesive 501 provided in the overlap region 100.

The first electrodes 13 are arranged to be physically spaced apart from the neighboring electrodes in the second direction, but they may be physically and electrically connected to each other by the conductive adhesive 501 provided in the overlap region 100. Accordingly, even if the first electrode 13 is not configured to include the pad or the bus electrode, a sufficient contact area with the second electrode 15 of the first solar cell 10a can be ensured.

Assuming that the second electrode 15 of the first solar cell 10a is provided so as to be physically apart from the neighboring electrode in the second direction such as the first electrode 13, even if the first electrode 13 and the second electrode 15 are disposed at positions shifted from each other in the overlap region 100, the first electrode 13 and the second electrode 15 can be electrically connected by the conductive adhesive 501.

In some implementations, the conductive adhesive 501 may be provided over the entire overlap region 100, and the conductive adhesive 501 may be made of conductive material such that the conductive adhesive 501 is sufficiently conductive to the junction 13a of the first electrode 13. The thickness of the adhesive 501 may be thicker than the thickness of the first electrode 13.

When the first solar cell 10a overlaps the second solar cell 10b, for example, the first solar cell 10a may be connected to the second solar cell 10b disposed in the overlap region 100, and the junction 13a may be positioned so as not to be seen from the front side.

For example, the junction 13a may have a maximum length (x-axis direction in the drawing) of the junction 13a so that the junction 13a can be disposed inside the overlap region 100 of the first solar cell 10a and the second solar cell 10b can be configured to be substantially equal to the width of the overlap region 100.

Thus, the junction 13a of the electrode is disposed only in the overlap region 100 and is not seen from the outside, so that the design of the solar cell module can be improved.

In some implementations, the width of the overlap region 100 along the first direction (x-axis direction in the drawing) is 1 to 2 (mm). If the width of the overlap region 100 is less than 1 mm, the amount of the conductive adhesive provided to the overlap region 100 is small and it is difficult to obtain a sufficient bonding force. If the width of the overlap region 100 is less than 2 mm, the light receiving surface is excessively reduced due to the overlap region 100, making it difficult to produce the desired output of the solar cell.

A manufacturing method for a solar cell module includes a step S11 of providing a conductive adhesive to a second solar cell having a plurality of electrodes provided at one end of the junction and arranged in parallel in the second direction, a step S13 of positioning the first solar cell so that the first solar cell is overlapped with the second solar cell provided with the conductive adhesive, and a step S15 of curing the conductive adhesive to physically electrically connect the first solar cell and the second solar cell.

In some examples, the junction 13a is disposed in an overlap region 100 in which the first solar cell and the second solar cell are overlapped and the conductive adhesive is provided so that the junction 13a of the plurality of electrodes in the overlap region 100 is connected to the neighboring electrode in the second direction.

In step S11, the conductive adhesive 501 may be applied onto the second solar cell 10b by a method such as a dispensing method. In some examples, the conductive adhesive 501 is applied to the front surface of the second solar cell 10b through the dispensing apparatus, wherein the conductive adhesive 501 is applied to the entire overlap region 100 and sufficiently covers the junction 13a.

Alternatively, the conductive adhesive 501 may be applied to the overlap region 100 of the first solar cell 10a or the overlap region of each of the first and second solar cells.

In step S13, a part of the first solar cell 10a and a part of the second solar cell 10b are arranged so as to overlap in the overlap region 100. The second surface (e.g., the rear surface) of the first solar cell 10a is positioned downward and the first surface (e.g., the front surface) of the second solar cell 10b is positioned upward. In this example, a part of the second electrode located on the rear surface of the first solar cell 10a and a part of the first electrode provided on the front surface of the second solar cell 10b may be arranged in the overlap region 100. For example, a part of the second electrode and a part of the first electrode are the junctions 13a, respectively. In the overlap region 100, the junction of the first electrode and the junction of the second electrode are disposed to face each other with the conductive adhesive 501 therebetween.

In step S15, the conductive adhesive may be cured by heat or ultraviolet (UV) light as a heat source. As the conductive adhesive is cured, the first solar cell 10a and the second solar cell 10b are physically bonded and electrically connected.

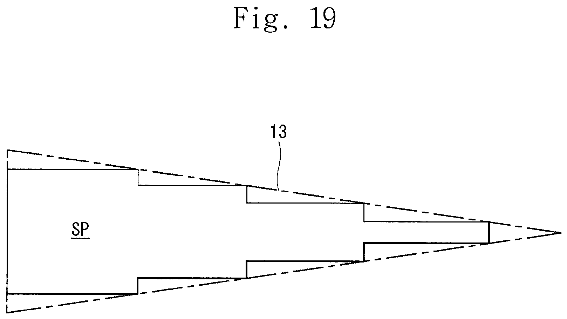

FIG. 19 is a diagram illustrating an example mask pattern used to yield an electrode in a needle shape.

In some implementations, the electrode 13 may be made by a screen printing method using a paste. The paste has a viscosity and is thermally cured by firing. However, if the paste is printed in the same shape as the electrode shape during the screen printing of the electrode, it may be impossible to perform the curing as the printed shape because the paste may cause thermal deformation during the curing process. For example, in the cases where the electrode has a needle shape, it may be difficult to form the electrode in a needle shape because the deformation of the paste occurring in the firing process is large.

In the manufacturing method according to the disclosure, the mask pattern SP is, for example, configured to have a stepped shape. For example, the mask pattern SP may be provided to have a top shape whose width gradually decreases in the longitudinal direction of the electrode 13 as illustrated in Fig 19.

Although there is an empty space due to the step and difference between the printed paste SP and the electrode 13, the paste SP may spread sideways in the process of firing to fill the space, and may be provided to have the same hypotenuse.

The number of steps may be determined based on variables such as the electrode size, paste viscosity, composition, and process temperature. For example, the number of steps may be 3 to 5.

Although implementations have been described with reference to a number of illustrative implementations thereof, it should be understood that numerous other modifications and implementations can be devised by those skilled in the art that will fall within the scope of the appended claims.

## Claims

1. A solar cell module, comprising:
a plurality of solar cells (10), each solar cell (10) including:
a short side (11a) that extends in a first direction,
a long side (11b) that extends in a second direction that is different than the first direction,
a first electrode (13) located on a first surface of each solar cell (10),
a second electrode (15) located on a second surface of each solar cell (10), and
an overlap region (100) disposed at the long side (11b) and configured to partially overlap a neighboring solar cell (10) along the long side (11b), wherein the plurality of solar cells (10) include a first solar cell (10a) and a second solar cell (10b) neighboring the first solar cell (10a),
wherein the solar cell module further includes a conductive adhesive (501) that electrically and physically connects the second electrode (15) of the first solar (10a) cell to the first electrode (13) of the second solar (10b) cell at the overlap region (100), and
wherein the first electrode (13) includes a plurality of electrodes that are physically spaced apart from each other in the second direction, each of the plurality of electrodes of the first electrode (13) including a junction (13a) disposed in the overlap region (100), each junction (13a) comprising a conductive material and providing an electrical and physical connection to a semiconductor substrate (11) of the solar cell (10),
**characterized in that** neighboring junctions (13a) of the plurality of electrodes of the first electrode (13) of the second solar cell (10b) are electrically and physically connected to each other by the conductive adhesive (501) at the overlap region (100), the junctions (13a) of the plurality of electrodes of the first electrode (13a) have an aspect ratio of 1/26 to 3/10 corresponding to a ratio between a length in the second direction and a length in the first direction, and
the plurality of electrodes of the first electrode (13) further include a finger portion (13b) extending from the junction (13a) in the first direction and having a line width less than a line width of the junction (13a) in the second direction, and the junction (13a) defines an open pattern (131) through which a portion of the semiconductor substrate (11) is exposed.

2. The solar cell module of claim 1, wherein a unit area of the junctions (13a) of the plurality of electrodes of the first electrode (13) is larger than a unit area of a portion of the plurality of electrodes of the first electrode (13) that excludes the junctions (13a).

3. The solar cell module of claim 1 or 2, wherein the junction (13) of each of the plurality of electrodes of the first electrode (13) located on the second solar cell (10b) is configured to be covered by the first solar cell (10a).

4. The solar cell module of claim 1, wherein the junctions (13a) of the plurality of electrodes of the first electrode (13) are located at an end of each electrode of the plurality of electrodes of the first electrode (13) adjacent to the first long side (11b) of the semiconductor substrate (11).

5. The solar cell module of claim 1, wherein an area occupied by the plurality of electrodes of the first electrode (13) is less than or equal to 5% of a total area of the at least one surface of the semiconductor substrate (11).

6. The solar cell module of claim 1, wherein the plurality of electrodes of the first electrode (13) are spaced apart from the first long side (11b) by a distance of 200 µm to 300 µm in the first direction.

7. The solar cell module of claim 1, wherein the plurality of electrodes of the first electrode (13) include 80 to 120 electrodes, and
wherein the plurality of electrodes of the first electrode (13) are spaced apart from each other by a distance of 1 mm to 2 mm in the second direction.

8. The solar cell module of claim 7, wherein the distance between neighboring electrodes in the plurality of electrodes of the first electrode (13) in the second direction is constant.

9. The solar cell module of claim 1, wherein a distance between two neighboring electrodes of the plurality of electrodes of the first electrode (13) in the second direction decreases along the first direction, and
wherein neighboring junctions (13a) of the two neighboring electrodes are positioned at locations in which the distance between the two neighboring electrodes in the second direction is at a minimum.

10. The solar cell module of claim 1, further comprising a busing portion that physically connects, in the second direction, two neighboring electrodes among the plurality of electrodes of the first electrode (13),
wherein the busing portion is located closer to a second long side (11b') opposite the first long side (11b), and the junctions (13a) of the plurality of electrodes of the first electrode (13) are located closer to the first long side (11b) than to the second long side (11b').

11. A method for manufacturing a solar cell module that includes first and second solar cells (10a, 10b), each solar cell (10) comprising a short side (11a) that extends in a first direction, a long side (11b) that extends in a second direction that is different than the first direction, the method comprising:
applying a conductive adhesive (501) to the second solar cell (10b), the second solar cell (10b) comprising a first electrode (13) including a plurality of electrodes that include a junction (13a) at an end of each electrode and that are arranged in parallel to the second direction, each junction (13a) comprising a conductive material and providing electrical and physical connection to a semiconductor substrate (11) of the solar cell (10);
positioning the first solar cell (10a) over the second solar cell (10b) at an overlap region (100) in which the conductive adhesive (501) is applied; and
curing the conductive adhesive (501) to physically and electrically connect the first solar cell (10a) to the second solar cell (10b),
wherein the junctions (13a) are disposed in the overlap region (100) based on the first solar cell (10a) overlapping the second solar cell (10b), and
wherein the conductive adhesive is configured to connect the junction (13a) of an electrode of the plurality of electrodes of the first electrode (13) in the overlap region to a neighboring junction (13a) of an electrode of the plurality of electrodes of the first electrode (13) that is spaced apart from the junction (13a) in the second direction,
**characterized in that** the junctions (13a) of the plurality of electrodes of the first electrode (13a) have an aspect ratio of 1/26 to 3/10 corresponding to a ratio between a length in the second direction and a length in the first direction, and the plurality of electrodes of the first electrode (13) further include a finger portion (13b) extending from the junction (13a) in the first direction and having a line width less than a line width of the junction (13a) in the second direction, and the junction (13a) defines an open pattern (131) through which a portion of the semiconductor substrate (11) is exposed.

## Patentansprüche

1. Solarzellenmodul, umfassend:
eine Vielzahl von Solarzellen (10), wobei jede Solarzelle (10) einschließt:
eine kurze Seite (11a), die sich in eine erste Richtung erstreckt,
eine lange Seite (11b), die sich in eine zweite Richtung erstreckt, die sich von der ersten Richtung unterscheidet,
eine erste Elektrode (13), die sich auf einer ersten Oberfläche jeder Solarzelle (10) befindet,
eine zweite Elektrode (15), die sich auf einer zweiten Oberfläche jeder Solarzelle (10) befindet, und
einen Überlappungsbereich (100), der an der langen Seite (11b) angeordnet und so konfiguriert ist, dass er eine benachbarte Solarzelle (10) entlang der langen Seite (11b) teilweise überlappt, wobei die Vielzahl von Solarzellen (10) eine erste Solarzelle (10a) und eine der ersten Solarzelle (10a) benachbarte zweite Solarzelle (10b) einschließt,
wobei das Solarzellenmodul ferner einen leitfähigen Klebstoff (501) einschließt, der die zweite Elektrode (15) der ersten Solarzelle (10a) im Überlappungsbereich (100) elektrisch und physikalisch mit der ersten Elektrode (13) der zweiten Solarzelle (10b) verbindet, und
wobei die erste Elektrode (13) eine Vielzahl von Elektroden einschließt, die in der zweiten Richtung physikalisch voneinander beabstandet sind, wobei jede der Vielzahl von Elektroden der ersten Elektrode (13) eine Verbindung (13a) einschließt, die im Überlappungsbereich (100) angeordnet ist, wobei jede Verbindung (13a) ein leitfähiges Material umfasst und eine elektrische und physikalische Verbindung mit einem Halbleitersubstrat (11) der Solarzelle (10) bereitstellt,
**dadurch gekennzeichnet, dass** benachbarte Übergänge (13a) der Vielzahl von Elektroden der ersten Elektrode (13) der zweiten Solarzelle (10b) durch den leitfähigen Klebstoff (501) im Überlappungsbereich (100) elektrisch und physikalisch miteinander verbunden sind, die Übergänge (13a) der Vielzahl von Elektroden der ersten Elektrode (13a) ein Längenverhältnis von 1/26 bis 3/10 aufweisen, das einem Verhältnis zwischen einer Länge in der zweiten Richtung und einer Länge in der ersten Richtung entspricht, und
die Vielzahl von Elektroden der ersten Elektrode (13) ferner einen Fingerabschnitt (13b) einschließt, der sich von dem Übergang (13a) in der ersten Richtung erstreckt und eine Linienbreite aufweist, die kleiner ist als eine Linienbreite des Übergangs (13a) in der zweiten Richtung, und der Übergang (13a) ein offenes Muster (131) definiert, durch das ein Abschnitt des Halbleitersubstrats (11) freiliegt.

2. Solarzellenmodul nach Anspruch 1, wobei eine Flächeneinheit der Übergänge (13a) der Vielzahl von Elektroden der ersten Elektrode (13) größer ist als eine Flächeneinheit eines Abschnitts der Vielzahl von Elektroden der ersten Elektrode (13), der die Übergänge (13a) ausschließt.

3. Solarzellenmodul nach Anspruch 1 oder 2, wobei der Übergang (13) jeder der Vielzahl von Elektroden der ersten Elektrode (13), die sich auf der zweiten Solarzelle (10b) befindet, so konfiguriert ist, dass sie von der ersten Solarzelle (10a) bedeckt wird.

4. Solarzellenmodul nach Anspruch 1, wobei sich die Übergänge (13a) der Vielzahl von Elektroden der ersten Elektrode (13) an einem Ende jeder Elektrode der Vielzahl von Elektroden der ersten Elektrode (13) neben der ersten langen Seite (11b) des Halbleitersubstrats (11) befinden.

5. Solarzellenmodul nach Anspruch 1, wobei eine von der Vielzahl von Elektroden der ersten Elektrode (13) eingenommene Fläche kleiner oder gleich 5 % einer Gesamtfläche der mindestens einen Oberfläche des Halbleitersubstrats (11) ist.

6. Solarzellenmodul nach Anspruch 1, wobei die Vielzahl von Elektroden der ersten Elektrode (13) von der ersten langen Seite (11b) in der ersten Richtung um einen Abstand von 200 µm bis 300 µm beabstandet sind.

7. Solarzellenmodul nach Anspruch 1, wobei die Vielzahl von Elektroden der ersten Elektrode (13) 80 bis 120 Elektroden einschließt, und
wobei die Vielzahl der Elektroden der ersten Elektrode (13) in der zweiten Richtung in einem Abstand von 1 mm bis 2 mm voneinander beabstandet sind.

8. Solarzellenmodul nach Anspruch 7, wobei der Abstand zwischen benachbarten Elektroden in der Vielzahl von Elektroden der ersten Elektrode (13) in der zweiten Richtung konstant ist.

9. Solarzellenmodul nach Anspruch 1, wobei ein Abstand zwischen zwei benachbarten Elektroden der Vielzahl von Elektroden der ersten Elektrode (13) in der zweiten Richtung entlang der ersten Richtung abnimmt, und
wobei benachbarte Übergänge (13a) der beiden benachbarten Elektroden an Stellen positioniert sind, an denen der Abstand zwischen den beiden benachbarten Elektroden in der zweiten Richtung minimal ist.

10. Solarzellenmodul nach Anspruch 1, ferner umfassend einen Sammelschienenabschnitt, der in der zweiten Richtung zwei benachbarte Elektroden aus der Vielzahl von Elektroden der ersten Elektrode (13) physikalisch verbindet,
wobei sich der Sammelschienenabschnitt näher an einer zweiten langen Seite (11b') gegenüber der ersten langen Seite (11b) befindet, und die Verbindungsstellen (13a) der Vielzahl von Elektroden der ersten Elektrode (13) sich näher an der ersten langen Seite (11b) als an der zweiten langen Seite (11b') befinden.

11. Verfahren zum Herstellen eines Solarzellenmoduls, das erste und zweite Solarzellen (10a, 10b) einschließt, wobei jede Solarzelle (10) eine kurze Seite (11a) umfasst, die sich in eine erste Richtung erstreckt, eine lange Seite (11b), die sich in eine zweite Richtung erstreckt, die sich von der ersten Richtung unterscheidet, wobei das Verfahren umfasst:
Aufbringen eines leitfähigen Klebstoffs (501) auf die zweite Solarzelle (10b), wobei die zweite Solarzelle (10b) eine erste Elektrode (13) umfasst, die eine Vielzahl von Elektroden einschließt, die an einem Ende jeder Elektrode einen Übergang (13a) einschließen und parallel zu der zweiten Richtung angeordnet sind, wobei jeder Übergang (13a) ein leitfähiges Material umfasst und eine elektrische und physikalische Verbindung mit einem Halbleitersubstrat (11) der Solarzelle (10) bereitstellt;
Positionieren der ersten Solarzelle (10a) über der zweiten Solarzelle (10b) in einem Überlappungsbereich (100), in dem der leitfähige Klebstoff (501) aufgetragen ist; und
Aushärten des leitfähigen Klebstoffs (501), um die erste Solarzelle (10a) physikalisch und elektrisch mit der zweiten Solarzelle (10b) zu verbinden,
wobei die Übergänge (13a) im Überlappungsbereich (100) angeordnet sind, basierend auf die Überlappung der ersten Solarzelle (10a) mit der zweiten Solarzelle (10b), und
wobei der leitfähige Klebstoff so konfiguriert ist, dass er den Übergang (13a) einer Elektrode der Vielzahl von Elektroden der ersten Elektrode (13) in dem Überlappungsbereich mit einem benachbarten Übergang (13a) einer Elektrode der Vielzahl von Elektroden der ersten Elektrode (13) verbindet, der in der zweiten Richtung von dem Übergang (13a) beabstandet ist,
**dadurch gekennzeichnet, dass** die Übergänge (13a) der Vielzahl von Elektroden der ersten Elektrode (13a) ein Längenverhältnis von 1/26 bis 3/10 aufweisen, das einem Verhältnis zwischen einer Länge in der zweiten Richtung und einer Länge in der ersten Richtung entspricht, und die Vielzahl von Elektroden der ersten Elektrode (13) ferner einen Fingerabschnitt (13b) einschließt, der sich von dem Übergang (13a) in der ersten Richtung erstreckt und eine Linienbreite aufweist, die geringer ist als eine Linienbreite des Übergangs (13a) in der zweiten Richtung, und der Übergang (13a) ein offenes Muster (131) definiert, durch das ein Abschnitt des Halbleitersubstrats (11) freiliegt.

## Revendications

1. Module de cellules solaires comprenant :
une pluralité de cellules solaires (10), chaque cellule solaire (10) comportant :
un petit côté (11a) qui s'étend dans une première direction,
un côté long (11b) qui s'étend dans une seconde direction qui est différente de la première direction,
une première électrode (13) située sur une première surface de chaque cellule solaire (10),
une seconde électrode (15) située sur une seconde surface de chaque cellule solaire (10), et
une région de chevauchement (100) disposée sur le côté long (11b) et conçue pour chevaucher partiellement une cellule solaire voisine (10) le long du côté long (11b), dans lequel la pluralité de cellules solaires (10) comportent une première cellule solaire (10a) et une seconde cellule solaire (10b) voisine de la première cellule solaire (10a),
dans lequel le module de cellule solaire comporte en outre un adhésif conducteur (501) qui relie électriquement et physiquement la seconde électrode (15) de la première cellule solaire (10a) à la première électrode (13) de la seconde cellule solaire (10b) au niveau de la zone de chevauchement (100), et
dans lequel la première électrode (13) comporte une pluralité d'électrodes physiquement espacées les unes des autres dans la seconde direction, chacune de la pluralité d'électrodes de la première électrode (13) comportant une jonction (13a) disposée dans la région de chevauchement (100), chaque jonction (13a) comprenant un matériau conducteur et fournissant une connexion électrique et physique à un substrat semi-conducteur (11) de la cellule solaire (10),
**caractérisé en ce que** les jonctions voisines (13a) de la pluralité d'électrodes de la première électrode (13) de la seconde cellule solaire (10b) sont électriquement et physiquement connectées les unes aux autres par l'adhésif conducteur (501) dans la zone de chevauchement (100), les jonctions (13a) de la pluralité d'électrodes de la première électrode (13a) ont un rapport d'aspect de 1/26 à 3/10 correspondant à un rapport entre une longueur dans la seconde direction et une longueur dans la première direction, et
la pluralité d'électrodes de la première électrode (13) comporte en outre une partie de doigt (13b) s'étendant à partir de la jonction (13a) dans la première direction et ayant une largeur de ligne inférieure à une largeur de ligne de la jonction (13a) dans la seconde direction, et la jonction (13a) définit un motif ouvert (131) à travers lequel une partie du substrat semi-conducteur (11) est exposée.

2. Module de cellules solaires selon la revendication 1, dans lequel une unité de surface des jonctions (13a) de la pluralité d'électrodes de la première électrode (13) est plus grande qu'une unité de surface d'une partie de la pluralité d'électrodes de la première électrode (13) qui exclut les jonctions (13a).

3. Module de cellules solaires selon la revendication 1 ou 2, dans lequel la jonction (13) de chacune de la pluralité d'électrodes de la première électrode (13) située sur la seconde cellule solaire (10b) est conçue pour être couverte par la première cellule solaire (10a).

4. Module de cellules solaires selon la revendication 1, dans lequel les jonctions (13a) de la pluralité d'électrodes de la première électrode (13) sont situées à une extrémité de chaque électrode de la pluralité d'électrodes de la première électrode (13) adjacente au premier côté long (11b) du substrat semi-conducteur (11).

5. Module de cellules solaires selon la revendication 1, dans lequel une zone occupée par la pluralité d'électrodes de la première électrode (13) est inférieure ou égale à 5 % d'une zone totale de l'au moins une surface du substrat semi-conducteur (11).

6. Module de cellules solaires selon la revendication 1, dans lequel la pluralité d'électrodes de la première électrode (13) sont espacées du premier côté long (11b) d'une distance de 200 µm à 300 µm dans la première direction.

7. Module de cellules solaires selon la revendication 1, dans lequel la pluralité d'électrodes de la première électrode (13) comporte 80 à 120 électrodes, et
dans lequel la pluralité d'électrodes de la première électrode (13) sont espacées les unes des autres d'une distance de 1 mm à 2 mm dans la seconde direction.

8. Module de cellules solaires selon la revendication 7, dans lequel la distance entre les électrodes voisines de la pluralité d'électrodes de la première électrode (13) dans la seconde direction est constante.

9. Module de cellules solaires selon la revendication 1, dans lequel une distance entre deux électrodes voisines de la pluralité d'électrodes de la première électrode (13) dans la seconde direction diminue le long de la première direction, et
dans lequel les jonctions voisines (13a) des deux électrodes voisines sont positionnées à des endroits où la distance entre les deux électrodes voisines dans la seconde direction est minimale.

10. Module de cellules solaires selon la revendication 1, comprenant en outre une partie d'interconnexion par bus qui relie physiquement, dans la seconde direction, deux électrodes voisines parmi la pluralité d'électrodes de la première électrode (13),
dans lequel la partie de passage est située plus près d'un second côté long (11b') opposé au premier côté long (11b), et les jonctions (13a) de la pluralité d'électrodes de la première électrode (13) sont situées plus près du premier côté long (11b) que du second côté long (11b').

11. Procédé de fabrication d'un module de cellules solaires, qui comporte une première et une seconde cellules solaires (10a, 10b), chaque cellule solaire (10) comprenant un côté court (11a) qui s'étend dans une première direction, un côté long (11b) qui s'étend dans une seconde direction qui est différente de la première direction, le procédé comprenant :
l'application d'un adhésif conducteur (501) sur la seconde cellule solaire (10b), la seconde cellule solaire (10b) comprenant une première électrode (13) comportant une pluralité d'électrodes qui comportent une jonction (13a) à une extrémité de chaque électrode et qui sont disposées parallèlement à la seconde direction, chaque jonction (13a) comprenant un matériau conducteur et fournissant une connexion électrique et physique à un substrat semi-conducteur (11) de la cellule solaire (10) ;
le positionnement de la première cellule solaire (10a) sur la seconde cellule solaire (10b) dans une zone de chevauchement (100) dans laquelle l'adhésif conducteur (501) est appliqué ; et
le durcissement de l'adhésif conducteur (501) pour connecter physiquement et électriquement la première cellule solaire (10a) à la seconde cellule solaire (10b),
dans lequel les jonctions (13a) sont disposées dans la région de chevauchement (100) en fonction du chevauchement de la première cellule solaire (10a) sur la seconde cellule solaire (10b), et
dans lequel l'adhésif conducteur est configuré pour connecter la jonction (13a) d'une électrode de la pluralité d'électrodes de la première électrode (13) dans la zone de chevauchement à une jonction voisine (13a) d'une électrode de la pluralité d'électrodes de la première électrode (13) qui est espacée de la jonction (13a) dans la seconde direction,
**caractérisé en ce que** les jonctions (13a) de la pluralité d'électrodes de la première électrode (13a) ont un rapport d'aspect de 1/26 à 3/10 correspondant à un rapport entre une longueur dans la seconde direction et une longueur dans la première direction, et la pluralité d'électrodes de la première électrode (13) comporte en outre une partie de doigt (13b) s'étendant à partir de la jonction (13a) dans la première direction et ayant une largeur de ligne inférieure à une largeur de ligne de la jonction (13a) dans la seconde direction, et la jonction (13a) définit un motif ouvert (131) à travers lequel une partie du substrat semi-conducteur (11) est exposée.
